(19) Europäisches Patentamt
European Patent Office
Office européen des brevets

(11) **EP 2 093 577 B1**

(12) **EUROPÄISCHE PATENTSCHRIFT**

(45) Veröffentlichungstag und Bekanntmachung des Hinweises auf die Patenterteilung:
**02.11.2011 Patentblatt 2011/44**

(51) Int Cl.:
*G01R 27/02* (2006.01)          *G01R 31/06* (2006.01)
*G01R 31/28* (2006.01)          *G01R 31/12* (2006.01)

(21) Anmeldenummer: **08003364.0**

(22) Anmeldetag: **25.02.2008**

(54) **Verfahren und Vorrichtung zum Prüfen einer energietechnischen Einrichtung**

Method and device for testing an energytechnical device

Procédé et dispositif de test d'un dispositif de technique d'énergie

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(43) Veröffentlichungstag der Anmeldung:
**26.08.2009 Patentblatt 2009/35**

(73) Patentinhaber: **Omicron electronics GmbH**
**6833 Klaus (AT)**

(72) Erfinder: **Kaufmann, Friedrich**
**6721 Thüringerberg (AT)**

(74) Vertreter: **Banzer, Hans-Jörg et al**
**Kraus & Weisert**
**Patent- und Rechtsanwälte**
**Thomas-Wimmer-Ring 15**
**80539 München (DE)**

(56) Entgegenhaltungen:
FR-A- 585 175          US-A- 5 633 801
US-A- 5 794 008          US-A- 5 963 410
US-A1- 2003 065 461

• **PEREZALONSO F ET AL: "Electrical characterization of VLSI packages" ELECTRONIC COMPONENTS AND TECHNOLOGY CONFERENCE, 1991. PROCEEDINGS., 41ST ATLANTA, GA, USA 11-16 MAY 1991, NEW YORK, NY, USA, IEEE, US, 11. Mai 1991 (1991-05-11), Seiten 62-69, XP010044362 ISBN: 978-0-7803-0012-5**
• **DAVID E ET AL: "Modeling of the Dielectric Response of a Stator Winding Insulation from a DC Ramp Test" IEEE TRANSACTIONS ON DIELECTRICS AND ELECTRICAL INSULATION, IEEE SERVICE CENTER, PISCATAWAY, NJ, US, Bd. 14, Nr. 6, 1. Dezember 2007 (2007-12-01), Seiten 1548-1558, XP011198827 ISSN: 1070-9878**

EP 2 093 577 B1

**Beschreibung**

Die vorliegende Erfindung betrifft ein Verfahren und eine Vorrichtung, um energietechnische Einrichtungen, wie z.B. Hochleistungstransformatoren, zu überprüfen.

Durch den ständig zunehmenden Kostendruck ist die Energiewirtschaft gezwungen, energietechnische Einrichtungen, wie z.B. Hochleistungstransformatoren, solange wie möglich im Einsatz zu belassen. Aus diesem Grund ist es umso wichtiger, eine korrekte Funktionsweise dieser energietechnischen Einrichtungen möglichst genau und mit einer möglichst kurzen Messzeit, um die Ausfallzeit der energietechnischen Einrichtung zu minimieren, zu überprüfen.

In "Electrical Characterization of VLSI Packages", von F. Perezalonso und anderen, Electronic Components and Technology Conference, 1991, IEEE Proceedings, Seiten 62 - 69 (ISBN: 978-0-7803-0012-5) wird offenbart, wie mittels einer Prüfspannung, welche monoton ansteigt, eine Induktivität oder Kapazität einer VLSI-Schaltung gemessen wird.

Die US 2003/0065461 A1 beschreibt einen Impedanz-Spektrometer für elektrochemische Vorrichtungen, welche mittels der Lapace Transformation arbeitet.

In "Modeling of the Dielectric Response of a Stator Winding Insulation from DC Ramp Test", von E. David und anderen, IEEE Transactions on Dielectrics and Electrical Insulation, Dezember 2007, Seiten 1548 - 1558, ISSN: 1070-9878 wird eine Modellierung einer dielektrischen Antwort einer Isolation einer Statorwicklung von einem Gleichspannungs-Rampentest beschrieben.

Die DE 101 35 915 B4 beschreibt ein Verfahren zur Diagnose der dielektrischen Alterung von Mehrstoffdielektrika, wobei sinusförmige Prüfspannungen eingesetzt werden.

Nach dem Stand der Technik ist es üblich, für diese Überprüfung ein sinusförmiges oder sprungförmiges Prüfsignal an die energietechnische Einrichtung anzulegen und dann Eigenschaften der energietechnischen Einrichtung anhand von Signalverläufen zu analysieren, welche abhängig von dem sprungartig angelegten Prüfsignal entstehen. Handelt es sich beispielsweise bei dem Prüfsignal um eine sprungförmige Spannung, welche an die energietechnischer Einrichtung angelegt wird, wird ein durch diese sprungförmige Spannung hervorgerufener Strom gemessen, woraus dann bestimmte Rückschlüsse auf die Eigenschaften der energietechnischen Einrichtung möglich sind. Allerdings ergibt sich in der Praxis durch das Anlegen einer sprungförmigen Spannung zumindest bei kapazitiven Prüfobjekten eine sehr große Stromspitze, was zu messtechnischen Problemen führt.

Allgemein ausgedrückt, ergeben sich aus der nach dem Stand der Technik üblichen Vorgehensweise, ein sprungförmiges Prüfsignal an die energietechnische Einrichtung anzulegen, messtechnische Probleme bei der Messung der sich daraus ergebenden Signalverläufe.

Daher ist es eine Aufgabe der vorliegenden Erfindung, ein Verfahren und eine Vorrichtung zum Prüfen einer energietechnischen Einrichtung bereitzustellen, wobei die vorab beschriebenen messtechnischen Probleme vermieden oder zumindest verringert werden.

Erfindungsgemäß wird diese Aufgabe durch ein Verfahren zum elektrischen Impedanz-Prüfen einer energietechnischen Einrichtung nach Anspruch 1 und eine Vorrichtung zum elektrischen Impedanz-Prüfen einer energietechnischen Einrichtung nach Anspruch 11 gelöst. Die abhängigen Ansprüche definieren bevorzugte und vorteilhafte Ausführungsformen der Erfindung.

Im Rahmen der vorliegenden Erfindung wird ein Verfahren zum Prüfen einer energietechnischen Einrichtung bereitgestellt. Dabei wird zum Prüfen der energietechnischen Einrichtung ein Prüfsignal an die energietechnische Einrichtung angelegt. Dieses Prüfsignal weist einen Verlauf auf, welcher ausgehend von einem Anfangswert stetig monoton auf einen vorbestimmten Endwert ansteigt und diesen Endwert über ein vorbestimmtes Zeitintervall beibehält. Dabei wird unter dem stetig monoton steigenden Verlauf ein Verlauf verstanden, bei welchem ein Anstieg des Verlaufes pro Zeiteinheit entsprechend begrenzt ist. Ein stetig ansteigender Verlauf ist gerade kein sprungförmiger Verlauf. Mit anderen Worten ist der hier gemeinte stetig monoton steigende Verlauf ein Verlauf, welcher flacher verläuft als ein nach dem Stand der Technik eingesetzter sprungförmiger Verlauf, welcher meist dadurch realisiert wird, dass mittels eines Relais ein hoher Prüfsignalwert (eine Spannung) plötzlich an die energietechnische Einrichtung angelegt wird. Monoton steigend bedeutet, dass der Verlauf innerhalb des vorbestimmten Zeitintervalls niemals absinkt.

Da das Prüfsignal einen stetig steigenden Verlauf, und gerade keinen sprungförmigen Verlauf, aufweist, weist die sich daraus ergebende Messantwort vorteilhafterweise keine Spitze auf, wie dies bei den nach dem Stand der Technik üblichen sprungförmigen Prüfsignalen der Fall ist. Daher kann die sich ergebende Messantwort vorteilhafterweise im Anfangsbereich (d.h. vom Beginn des Anlegens des Prüfsignals an) gemessen werden, was nach dem Stand der Technik aufgrund des hohen Spitzenwerts am Anfang nicht möglich ist.

Insbesondere ist das Prüfsignal eine Spannung, mittels welcher ein Strom in der energietechnischen Einrichtung verursacht wird, dessen Stromverlauf gemessen wird. Aus einem Verhältnis aus einem Spannungsverlauf dieser Spannung und dem resultierenden Stromverlauf kann dann zumindest eine elektrische Eigenschaft der energietechnischen Einrichtung bestimmt werden.

Die wesentliche erfinderische Idee besteht darin anstelle des nach dem Stand der Technik eingesetzten Sprunges einen "soft Step" zu verwenden, durch welchen hohe Ladeströme zu Beginn der Sprungantwort vermieden werden.

Bei der elektrischen Eigenschaft der energietechnischen Einrichtung handelt es sich um eine Impedanz (insbesondere um einen Frequenzgang einer Impedanz) der energietechnischen Einrichtung.

Diese elektrische Eigenschaft, d.h. die Impedanz oder der Frequenzgang der Impedanz, wird dabei insbesondere für sehr niedrige Frequenzen von weniger als 10 Hz bestimmt.

Für niedrige Frequenzen kann zwar auch das FDS-Verfahren ("Frequency Domain Spectroscopy"-Verfahren) eingesetzt werden, welches aber im Vergleich zu dem erfindungsgemäßen Verfahren eine sehr viel längere Messzeit benötigt.

Der Spannungsverlauf kann bei dem erfindungsgemäßen Verfahren ausgehend von dem Anfangswert bis zu dem Endwert rampenförmig, in der Form von zwei aneinander hängenden Parabelbögen oder halb-sinusförmig erfolgen.

Dabei ist der Endwert insbesondere größer als 100 V oder besser größer als 200 V.

Die Impedanz Z(s) kann aus dem Spannungsverlauf u(t) und dem Stromverlauf i(t) mittels der Laplace-Transformation bestimmt werden, wie es ist in der folgenden Gleichung (1) angegeben ist

$$Z(s) = \frac{L\{u(t)\}}{L\{i(t)\}} \qquad \text{Voraussetzung: } u(t) = 0 \text{ und } i(t) = 0 \text{ für } t < 0 \qquad (1).$$

Das vorbestimmte Zeitintervall, in welchem das Prüfsignal den vorbestimmten Endwert beibehält, ist insbesondere länger als 10 Minuten und liegt unterhalb von 5 Stunden.

Der Stromverlauf wird dabei über einen gewissen Zeitraum (z.B. 10 Minuten bis 5 Stunden) gemessen und der weitere Verlauf, also der Verlauf nach dem weiteren Zeitraum, extrapoliert. Eine lange Messzeit ist nur dann notwendig, wenn der Frequenzgang der Impedanz auch für ganz tiefe Frequenzen (z.B. bei 0,0001 Hz) gemessen werden soll.

Es sei angemerkt, dass die Impedanz bzw. die Impedanzfunktion über der Frequenz eines Zweipols diesen Zweipol vollständig charakterisiert, so dass aus der Impedanz auch weitere elektrische Eigenschaften abgeleitet werden können.

Mit dem erfindungsgemäßen Verfahren wird eine Isolation der energietechnischen Einrichtung, insbesondere eine Isolation eines Hochleistungstransformators, überprüft.

Über die Messung der Impedanz der Isolation eines Hochleistungstransformators können die elektrischen Eigenschaften dieser Isolation, d.h. der Wassergehalt in einem festen Teil der Isolation (Papier, Pressspan) bestimmt werden. Darüber können dann die Güte dieser Isolation und damit die Eigenschaft des Hochleistungstransformators bestimmt werden.

Im Rahmen der vorliegenden Erfindung wird auch eine Vorrichtung zum Prüfen einer energietechnischen Einrichtung bereitgestellt. Die Vorrichtung ist derart ausgestaltet, dass die Vorrichtung ein Prüfsignal an die energietechnische Einrichtung anlegt. Dabei lässt die Vorrichtung das Prüfsignal ausgehend von einem Anfangswert stetig monoton auf einen vorbestimmten Endwert ansteigen. Dieser Endwert wird dann von dem Prüfsignal über ein vorbestimmtes Zeitintervall lang beibehalten.

Die Vorteile der erfindungsgemäßen Vorrichtung entsprechen im Wesentlichen den Vorteilen des erfindungsgemäßen Verfahrens, welche vorab im Detail ausgeführt sind, weshalb hier auf eine Wiederholung verzichtet wird.

Bei einer erfindungsgemäßen Ausführungsform umfasst die Vorrichtung einen Spannungsgenerator, Strommessmittel und Auswertungsmittel. Der Spannungsgenerator erzeugt das Prüfsignal in Form einer Spannung und legt diese Spannung an die energietechnische Einrichtung an. Die Strommessmittel messen einen Verlauf eines Stromes, über der energietechnischen Einrichtung, welcher durch die von dem Spannungsgenerator angelegte Spannung verursacht wird. Die Auswertungsmittel bilden ein Verhältnis aus einem Spannungsverlauf der Spannung und dem Stromverlauf und bestimmen abhängig von diesem Verhältnis eine elektrische Eigenschaft, insbesondere die Impedanz oder den Frequenzgang der Impedanz, der energietechnischen Einrichtung.

Die vorliegende Erfindung ist insbesondere geeignet, um die elektrischen Eigenschaften einer Isolation bei Hochleistungstransformatoren zu messen. Anders ausgedrückt lässt sich durch die vorliegende Erfindung der Zustand der Isolation (z.B. Öl und Zellulose) überprüfen, woraus dann die Entscheidung abgeleitet werden kann, ob der Transformator länger sicher betrieben werden kann oder nicht. Selbstverständlich ist die vorliegende Erfindung nicht auf diesen bevorzugten Anwendungsbereich beschränkt. Die vorliegende Erfindung kann beispielsweise auch zur Bewertung von Isolationen von Erdkabeln, welche Öl und Papierisolationen umfassen, eingesetzt werden. Darüber hinaus können mit der vorliegenden Erfindung auch kritische Durchführungen bei Transformatoren untersucht werden. Allgemein kann man die Erfindung auch außerhalb des Gebietes der energietechnischen Einrichtungen bei Materialuntersuchungen verwenden.

Die vorliegende Erfindung wird nachfolgend näher unter Bezugnahme auf die beigefügte Zeichnung anhand bevorzugter Ausführungsbeispiele erläutert.

Fig. 1 stellt schematisch eine erfindungsgemäße Anordnung zur Messung einer Impedanz dar.

Fig. 2a stellt einen erfindungsgemäßen Spannungsverlauf und Fig. 2b einen dadurch verursachten Stromverlauf für einen idealen Kondensator dar.

Fig. 3a stellt einen anderen erfindungsgemäßen Spannungsverlauf und Fig. 3b einen dadurch verursachten Stromverlauf für einen idealen Kondensator dar.

Fig. 4a stellt einen weiteren erfindungsgemäßen Spannungsverlauf und Fig. 4b einen dadurch verursachten Stromverlauf für einen idealen Kondensator dar.

Fig. 5 stellt schematisch eine erfindungsgemäße Vorrichtung zur Messung einer Impedanz einer Isolation eines Hochleistungstransformators dar.

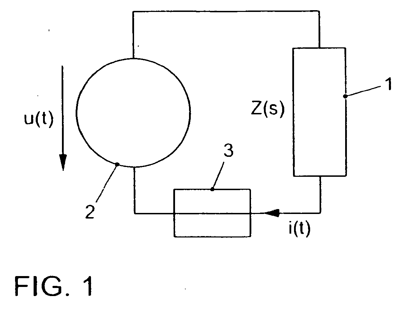

Fig. 1 stellt schematisch eine erfindungsgemäße Anordnung bestehend aus einem Spannungsgenerator 2 und einem Strommessgerät 3 zur Bestimmung einer Impedanz eines Prüflings 1 (einer Isolation) dar. Aus einem von dem Strommessgerät 3 gemessenen Stromverlauf i(t) und einem von dem Spannungsgenerator 2 erzeugten Spannungsverlauf u(t) lässt sich mit der vorab beschriebenen Laplace-Transformation die Impedanz Z(s) bestimmen (siehe Gleichung 1 oben).

Dabei transformiert die Laplace-Transformation eine gegebene Funktion f(t) vom reellen Zeitbereich in eine Funktion F(s) im komplexen Spektralbereich (Frequenzbereich) unter der Voraussetzung u(t) = 0 und i(t) = 0 für t < 0, wie es durch die folgende Gleichung 2 angegeben ist

$$L\{f(t)\} = \overline{F}(s) = \int_0^\infty f(t)e^{-st}\,dt \qquad s \,\varepsilon\, C \qquad (2).$$

Wenn man für die von dem Spannungsgenerator 2 angelegte Spannung einen idealen Sprung mit der Spannung $U_0$ annimmt, ist die daraus resultierende Laplace-Transformation der Spannung sehr einfach, wie es in der unten angegebenen Gleichung 3 dargestellt ist

$$L\{u(t)\} = \frac{U_0}{s} \qquad \text{wenn } u(t) = 0 \text{ für } t < 0 \text{ und } u(t) = U_0 \text{ für } t \geq 0 \qquad (3).$$

Im praktischen Fall ergibt sich jedoch bei kapazitiven Messerobjekten, dass der Strom durch den Sprung der Spannung sehr groß (theoretisch unendlich groß) wird und nur durch Verlustwiderstände begrenzt ist. Diese Stromspitze am Anfang des Stromverlaufes kann praktisch von dem Strommessgerät 3 nicht korrekt gemessen werden.

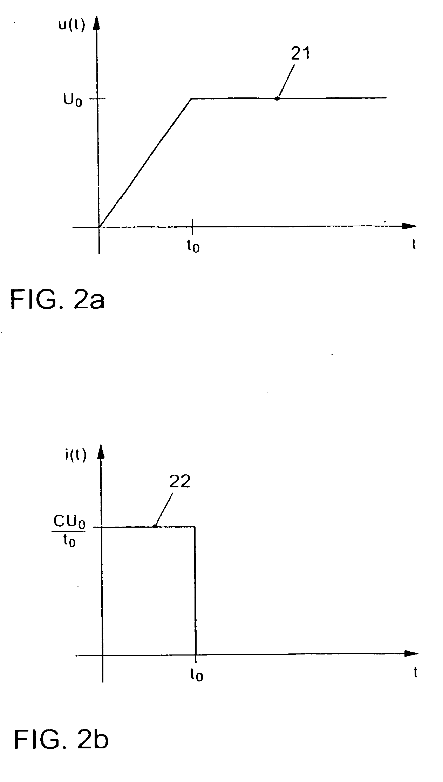

In Fig. 2a ist ein erfindungsgemäßer Spannungsverlauf 21 dargestellt, welcher durch die folgende Gleichung (4) beschrieben wird

$$u(t) = 0 \qquad \text{für} \quad t < 0,$$
$$u(t) = \frac{U_0}{t_0} \times t \qquad \text{für} \quad 0 \leq t \leq t_0,$$
$$u(t) = U_0 \qquad \text{für} \quad t > t_0, \qquad (4).$$

Die vorbestimmte Zeitspanne $t_0$ ist dabei länger als 100 ms aber kürzer als 1 Minute. Bevorzugt ist auch eine Zeitspanne t0 von mindestens 5 s aber maximal 10 s.

Wenn es sich bei dem Prüfling 1 um einen idealen Kondensator handelt, ergibt sich der in Fig. 2b dargestellte Stromverlauf.

Man erkennt, dass dieser Stromverlauf vorteilhafterweise keine Stromspitze aufweist, wie es bei einem sprungförmigen Spannungsverlauf, welcher wie bereits mehrfach angemerkt nach dem Stand der Technik eingesetzt wird, der Fall ist; Daher kann der in Fig. 2b dargestellte Stromverlauf auch vollständig, gerade auch im Anfangsbereich, von dem Strommessgerät 3 gemessen werden.

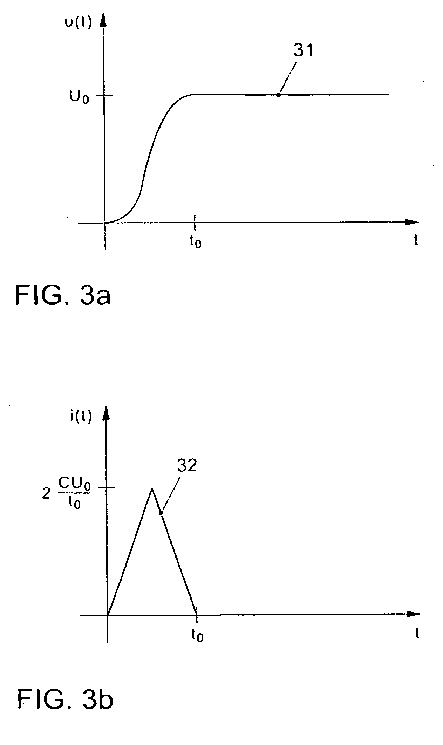

In Fig. 3a ist ein weiterer erfindungsgemäßer Spannungsverlauf mit einer begrenzten Anstiegszeit des Spannungsverlauf über der Zeit dargestellt, welcher aus zwei Parabelbögen zusammengesetzt ist und durch die folgende Gleichung (5) beschrieben wird

$$u(t) = 0 \qquad \text{für} \quad t < 0,$$

$$u(t) = 2U_0 \times \left(\frac{t}{t_0}\right)^2 \qquad \text{für} \quad 0 \le t \le \frac{t_0}{2},$$

$$u(t) = U_0 \times \left[1 - 2 \times \left(1 - \frac{t}{t_0}\right)^2\right] \qquad \text{für} \quad \frac{t_0}{2} \le t \le t_0,$$

$$u(t) = U_0 \qquad \text{für} \quad t > t_0. \qquad (5)$$

Die vorbestimmte Zeitspanne $t_0$ ist dabei länger als 100 ms aber kürzer als 1 Minute. Bevorzugt ist auch eine Zeitspanne t0 von mindestens 5 s aber maximal 10 s.

Wiederum an einem idealen Kondensator ergibt sich ein dreieckförmiger Stromverlauf 32, welcher in Fig. 3b dargestellt ist. Auch dieser Stromverlauf 32 weist keine Stromspitze auf, wie es nach dem Stand der Technik bei einer angelegten sprungförmigen Spannung der Fall ist. Im Vergleich zu dem in Fig. 2b dargestellten Stromverlauf 22 weist der Stromverlauf 32 der Fig. 3b zusätzlich den Vorteil auf, dass der Stromverlauf 32 nicht sprungförmig ist, wie es bei dem in Fig. 2b dargestellten Stromverlauf 22 der Fall ist. Dadurch kann der Stromverlauf 32 gerade im Anfangsbereich von dem Strommessgerät 3 besser oder genauer gemessen werden.

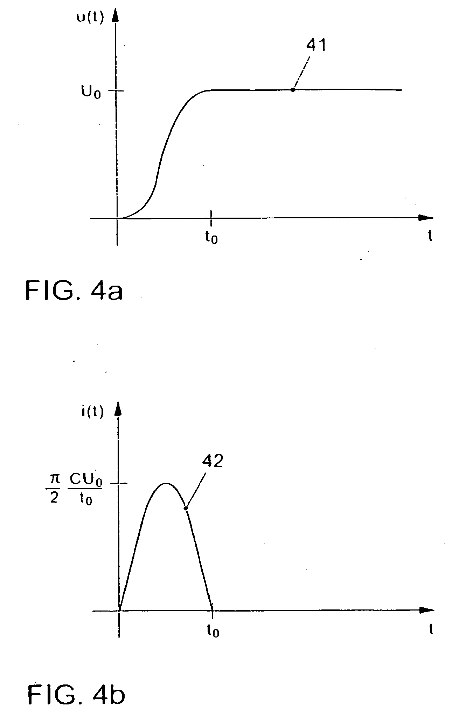

In Fig. 4a ist schließlich noch ein anderer erfindungsgemäßer Spannungsverlauf dargestellt, welcher einen halb-sinusförmigen Anstieg aufweist und durch die folgende Gleichung 6 beschrieben wird

$$u(t) = 0 \qquad \text{für} \quad t < 0,$$

$$u(t) = U_0 \times \sin^2\left(\frac{\pi}{2} \times \frac{t}{t_0}\right) \qquad \text{für} \quad 0 \le t \le t_0,$$

$$u(t) = U_0 \qquad \text{für} \quad t > t_0. \qquad (6)$$

Wiederum ist die vorbestimmte Zeitspanne $t_0$ ist dabei länger als 100 ms aber kürzer als 1 Minute. Bevorzugt ist auch hier eine Zeitspanne t0 von mindestens 5 s aber maximal 10 s.

Darüber hinaus ist $U_0$ größer als 100 V und besser größer als 200 V, was für alle in den Figuren 2 bis 4 dargestellten Ausführungsformen gilt.

Dieser erfindungsgemäße Spannungsverlauf 41 führt bei einem idealen Kondensator zu dem in Fig. 4b dargestellten Stromverlauf 42, welcher wiederum vorteilhafterweise keine nach dem Stand der Technik übliche Stromspitze aufweist. Im Gegensatz zu dem in Fig. 2b dargestellten Stromverlauf 22 weist der in Fig. 4b dargestellte Stromverlauf 42 keinen Sprung auf und weist zusätzlich gegenüber dem in Fig. 3b dargestellten Stromverlauf 32 den Vorteil auf, dass es zu keiner abrupten Änderung beim Anstieg bzw. Abfall des Stromes kommt, wie es bei dem Stromverlauf 32 durch die Spitze des Dreiecks der Fall ist. Da diese Spitze des Dreiecks von dem Strommessgerät 3 nur schwer korrekt gemessen werden kann, weist der in Fig. 4b dargestellte Stromverlauf 42 und damit der in Fig. 4a dargestellte Spannungsverlauf 41 gegenüber der in Fig. 3a und Fig. 3b dargestellten Ausführungsform einen Vorteil auf.

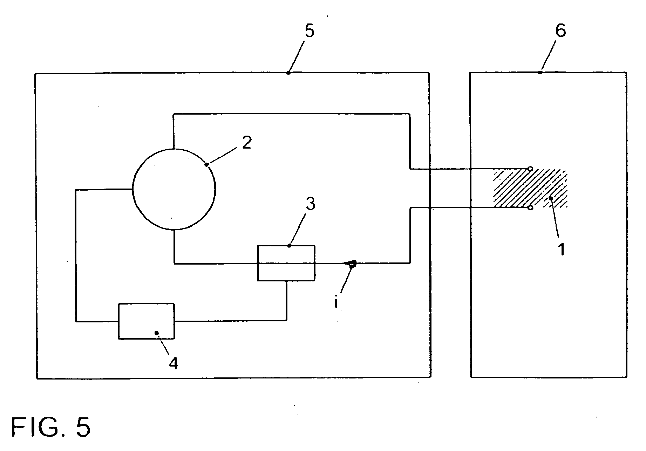

In Fig. 5 ist eine erfindungsgemäße Ausführungsform einer Vorrichtung 5 zur Bestimmung einer Impedanz eines Isolators oder einer Isolation 1 eines Hochleistungstransformators 6 dargestellt. Dabei umfasst die Vorrichtung 5 einen Spannungsgenerator 2, ein Strommessgerät 3 und eine Auswertungsvorrichtung 4. Über den Spannungsgenerator 2 wird eine Spannung an die Isolation 1 angelegt, welche einen Strom i durch die Isolation 1 hervorruft, welcher durch das Strommessgerät 3 gemessen wird. Aus dem Verhältnis zwischen dem Spannungsverlauf der von dem Spannungsgenerator 2 erzeugten Spannung und dem Stromverlauf, welcher von dem Strommessgerät 3 gemessen wird, ermittelt die Auswertungsvorrichtung 4 eine Impedanz der Isolation 1 für Frequenzen unterhalb von 10 Hz. Über die Kenntnis dieser Impedanz, welche man auch als Frequenzgang der Isolation 1 bezeichnen kann, können dann verschiedene andere elektrische Größen abgeleitet werden. Dazu zählt beispielsweise der Verlustfaktor tan(delta) in Abhängigkeit von der Frequenz, über welchen dann ausgehend von bekannten Verläufen dieses Verlustfaktors in Abhängigkeit von der Frequenz bei verschiedenen Feuchtigkeitswerten der Isolation auf den Wassergehalt im Papier der Isolation 1 geschlossen werden kann.

Die Erzeugung eines erfindungsgemäßen Spannungsverlaufs mit begrenzter Anstiegsgeschwindigkeit kann bei einer nicht dargestellten Ausführungsform auch mit einem digitalen Signalgenerator und einem entsprechenden Verstärker zur Erzeugung der notwendigen Spannungen vorgenommen werden.

**Patentansprüche**

1.  Verfahren zum Messen einer Impedanz einer Isolation einer energietechnischen Einrichtung,
    wobei ein Prüfsignal an die energietechnische Einrichtung (6) angelegt wird, welches ausgehend von einem Anfangswert auf einen vorbestimmten Endwert ($U_0$) stetig monoton ansteigt und diesen Endwert ($U_0$) über ein vorbe-stimmtes Zeitintervall beibehält, und
    wobei zum Messen der Impedanz der Isolation ein Stromverlauf (22; 32; 42) eines Stromes in der energietechnischen Einrichtung (6) vom Beginn des Anlegens des Prüfsignals über das vorbestimmte Zeitintervall hinweg gemessen wird.

2.  Verfahren nach Anspruch 1,
    **dadurch gekennzeichnet,**
    **dass** das Prüfsignal eine Spannung ist, und
    **dass** aus einem Verhältnis aus einem Spannungsverlauf (21; 31; 41) der Spannung und dem Stromverlauf (22; 32; 42) die Impedanz der Isolation der energietechnischen Einrichtung (6) bestimmt wird.

3.  Verfahren nach Anspruch 2,
    **dadurch gekennzeichnet,**
    **dass** die Impedanz für Frequenzen unterhalb von 10 Hz bestimmt wird.

4.  Verfahren nach Anspruch 2 oder 3,
    **dadurch gekennzeichnet,**
    **dass** die Impedanz Z(s) aus dem Spannungsverlauf u(t) und dem Stromverlauf i(t) mittels der Laplace-Transformation wie folgt bestimmt wird:

$$Z(s) = \frac{L\{\dot{u}(t)\}}{L\{\dot{i}(t)\}}.$$

5.  Verfahren nach einem der Ansprüche 2-4,
    **dadurch gekennzeichnet,**
    **dass** der Spannungsverlauf u(t) über der Zeit t folgenden Beziehungen genügt:

$$u(t) = 0 \qquad \text{für} \qquad t < 0,$$

$$u(t) = \frac{U_0}{t_0} \times t \qquad \text{für} \qquad 0 \le t \le t_0,$$

$$u(t) = U_0 \qquad \text{für} \qquad t > t_0,$$

wobei $U_0$ eine vorbestimmte Spannung ist, und wobei $t_0$ eine vorbestimmte Zeitspanne ist, welche länger als 100 ms ist.

6. Verfahren nach einem der Ansprüche 2-4,
   **dadurch gekennzeichnet,**
   **dass** der Spannungsverlauf u(t) über der Zeit t folgenden Beziehungen genügt:

$$u(t) = 0 \qquad \text{für} \qquad t < 0,$$

$$u(t) = 2U_0 \times \left(\frac{t}{t_0}\right)^2 \qquad \text{für} \qquad 0 \le t \le \frac{t_0}{2},$$

$$u(t) = U_0 \times \left[1 - 2 \times \left(1 - \frac{t}{t_0}\right)^2\right] \qquad \text{für} \qquad \frac{t_0}{2} \le t \le t_0,$$

$$u(t) = U_0 \qquad \text{für} \qquad t > t_0,$$

wobei $U_0$ eine vorbestimmte Spannung ist, und wobei $t_0$ eine vorbestimmte Zeitspanne ist, welche länger als 100 ms ist.

7. Verfahren nach einem der Ansprüche 2-4,
   **dadurch gekennzeichnet,**
   **dass** der Spannungsverlauf u(t) über der Zeit t folgenden Beziehungen genügt:

$$u(t) = 0 \qquad \text{für} \qquad t < 0,$$

$$u(t) = U_0 \times \sin^2\left(\frac{\pi}{2} \times \frac{t}{t_0}\right) \qquad \text{für} \qquad 0 \le t \le t_0,$$

$$u(t) = U_0 \qquad \text{für} \qquad t > t_0,$$

wobei $U_0$ eine vorbestimmte Spannung ist, und wobei $t_0$ eine vorbestimmte Zeitspanne ist, welche länger als 100 ms ist.

8. Verfahren nach einem der Ansprüche 5-7,
   **dadurch gekennzeichnet,**
   **dass** $U_0$ größer als 100 V ist.

9. Verfahren nach einem der vorhergehenden Ansprüche,
   **dadurch gekennzeichnet,**
   **dass** das vorbestimmte Zeitintervall länger als 10 Minuten ist.

10. Verfahren nach einem der vorhergehenden Ansprüche,
    **dadurch gekennzeichnet,**
    **dass** die energietechnische Einrichtung ein Hochleistungstransformator (6) ist.

**11.** Vorrichtung zum Messen einer Impedanz einer Isolation einer energietechnischen Einrichtung (6), wobei die Vorrichtung (5) derart ausgestaltet ist, dass die Vorrichtung (5) ein Prüfsignal derart an die energietechnische Einrichtung (6) anlegt, dass das Prüfsignal ausgehend von einem Anfangswert auf einen vorbestimmten Endwert ($U_0$) stetig monoton ansteigt und diesen Endwert ($U_0$) über ein vorbestimmtes Zeitintervall beibehält, und wobei die Vorrichtung (5) derart ausgestaltet ist, dass die Vorrichtung (5) zum Messen der Impedanz der Isolation vom Beginn des Anlegens des Prüfsignals über das vorbestimmte Zeitintervall hinweg einen Stromverlauf (22; 32; 42) eines Stroms in der energietechnischen Einrichtung (6) misst.

**12.** Vorrichtung nach Anspruch 11,
**dadurch gekennzeichnet,**
**dass** die Vorrichtung (5) einen Spannungsgenerator (2), Strommessmittel (3) und Auswertungsmittel (4) umfasst, wobei der Spannungsgenerator (2) eine Spannung als das Prüfsignal erzeugt und als die Spannung an die energietechnische Einrichtung (6) anlegt,
**dass** die Strommessmittel (3) den Stromverlauf (22; 32; 42) über der energietechnischen Einrichtung (6) messen, und
**dass** die Auswertungsmittel (4) aus einem Verhältnis aus einem Spannungsverlauf (21; 31; 41) der Spannung und dem Stromverlauf (22; 32; 42) die Impedanz der Isolation der energietechnischen Einrichtung (6) bestimmen.

**13.** Vorrichtung nach Anspruch 11 oder 12,
**dadurch gekennzeichnet,**
**dass** die Vorrichtung (5) zur Durchführung des Verfahrens nach einem der Ansprüche 1-10 ausgestaltet ist.


**Claims**

**1.** Method of measuring an impedance of an insulation of a power engineering device, wherein a test signal is applied to the power engineering device (6), which test signal, starting from an initial value, rises steadily monotonically to a predetermined final value ($U_0$) and retains this final value ($U_0$) over a predetermined time interval, and wherein, for measuring the impedance of the insulation, a current profile (22; 32; 42) of a current in the power engineering device (6) is measured from the beginning of the application of the test signal throughout the predetermined time interval.

**2.** Method according to Claim 1,
**characterized in that**
the test signal is a voltage, and
that from a ratio between a voltage profile (21; 31; 41) of the voltage and the current profile (22; 32; 42), the impedance of the insulation of the power engineering device (6) is determined.

**3.** Method according to Claim 2,
**characterized in that**
the impedance is determined for frequencies below 10 Hz.

**4.** Method according to Claim 2 or 3,
**characterized in that**
the impedance Z(s) is determined from the voltage profile u(t) and the current profile i(t) by means of the Laplace transformation, as follows:

$$Z(s) = \frac{L\{u(t)\}}{L\{i(t)\}} \ .$$

**5.** Method according to any one of Claims 2 to 4,
**characterized in that**
the voltage profile u(t) over time t fits the following relations:

$$u(t) = 0 \qquad \text{for } t < 0,$$

$$u(t) = \frac{U_0}{t_0} \times t \qquad \text{for } 0 \leq t \leq t_0,$$

$$u(t) = U_0 \qquad \text{for } t > t_0,$$

where $U_0$ is a predetermined voltage, and $t_0$ is a predetermined time span which is longer than 100 ms.

6. Method according to any one of Claims 2 to 4,
   **characterized in that**
   the voltage profile u(t) over time t fits the following relations:

$$u(t) = 0 \qquad \text{for } t < 0,$$

$$u(t) = 2\,U_0 \times \left(\frac{t}{t_0}\right)^2 \qquad \text{for } 0 \leq t \leq \frac{t_0}{2},$$

$$u(t) = U_0 \times \left[1 - 2 \times \left(1 - \frac{t}{t_0}\right)^2\right] \qquad \text{for } \frac{t_0}{2} \leq t \leq t_0,$$

$$u(t) = U_0 \qquad \text{for } t > t_0,$$

where $U_0$ is a predetermined voltage, and $t_0$ is a predetermined time span which is longer than 100 ms.

7. Method according to any one of Claims 2 to 4,
   **characterized in that**
   the voltage profile u(t) over time t fits the following relations:

$$u(t) = 0 \qquad \text{for } t < 0,$$

$$u(t) = U_0 \times \sin^2\left(\frac{\pi}{2} \times \frac{t}{t_0}\right) \qquad \text{for } 0 \le t \le t_0,$$

$$u(t) = U_0 \qquad \text{for } t > t_0,$$

where $U_0$ is a predetermined voltage, and $t_0$ is a predetermined time span which is longer than 100 ms.

8. Method according to any one of Claims 5 to 7,
   **characterized in that**
   $U_0$ is greater than 100 V.

9. Method according to any one of the preceding claims,
   **characterized in that**
   the predetermined time interval is longer than 10 minutes.

10. Method according to any one of the preceding claims,
    **characterized in that**
    the power engineering device is a high-power transformer (6) .

11. Apparatus for measuring an impedance of an insulation of a power engineering device (6),
    wherein the apparatus (5) is designed such that the apparatus (5) applies a test signal to the power engineering device (6) in such a way that the test signal rises from an initial value steadily monotonically to a predetermined final value ($U_0$) and retains this final value ($U_0$) over a predetermined time interval, and wherein the apparatus (5) is designed such that, for measuring the impedance of the insulation, the apparatus (5) measures a current profile (22; 32; 42) of a current in the power engineering device (6) from the beginning of the application of the test signal throughout the predetermined time interval.

12. Apparatus according to Claim 11,
    **characterized in that**
    the apparatus (5) comprises a voltage generator (2), current measurement means (3) and analysis means (4), the voltage generator (2) generating a voltage as the test signal, and applying it as the voltage to the power engineering device (6),
    the voltage measurement means (3) measure the current profile (22; 32; 42) via the power engineering device (6), and the analysis means (4), from a ratio from a voltage profile (21; 31; 41) of the voltage and the current profile (22; 32; 42), determine the impedance of the insulation of the power engineering device (6).

13. Apparatus according to Claim 11 or 12,
    **characterized in that**
    the apparatus (5) is designed to carry out the method according to any one of Claims 1 to 10.

**Revendications**

1. Procédé pour mesurer une impédance d'une isolation d'un dispositif de génie énergétique,
   un signal de test étant appliqué au dispositif de génie énergétique (6) lequel, en partant d'une valeur initiale, augmente de façon continue monotone jusqu'à une valeur finale prédéterminée ($U_0$) et conserve cette valeur finale ($U_0$) tout au long d'un intervalle de temps prédéterminé, et
   pour mesurer l'impédance de l'isolation, une variation de courant (22 ; 32 ; 42) d'un courant dans le dispositif de génie énergétique (6) étant mesurée à partir du début de l'application du signal de test tout au long de l'intervalle de temps prédéterminé.

2. Procédé selon la revendication 1,
   **caractérisé en ce que** le signal de test est une tension, et
   **en ce que** l'on détermine, à partir d'un rapport entre une variation de tension (21 ; 31 ; 41) de la tension et la variation du courant (22 ; 32 ; 42), l'impédance de l'isolation du dispositif de génie énergétique (6).

3. Procédé selon la revendication 2, **caractérisé en ce que** l'impédance est déterminée pour des fréquences inférieures à 10 Hz.

4. Procédé selon la revendication 2 ou 3, **caractérisé en ce que** l'impédance Z(s) est déterminée à partir de la variation de la tension u(t) et de la variation du courant i(t) à l'aide de la transformation de Laplace de la manière suivante :

$$Z(s) = \frac{L\{u(t)\}}{L\{i(t)\}}.$$

5. Procédé selon l'une des revendications 2-4, **caractérisé en ce que** la variation de la tension u(t) dans le temps t satisfait aux rapports suivantes :

$$u(t) = 0 \ \text{pour} \ t < 0,$$

$$u(t) = \frac{U_0}{t_0} \times t \quad \text{pour} \quad 0 \leq t \leq t_0,$$

$$u(t) = U_0 \quad \text{pour} \quad t > t_0.$$

$U_0$ étant une tension prédéterminée, et $t_0$ étant un intervalle de temps prédéterminé, lequel est plus long que 100 ms.

6. Procédé selon l'une des revendications 2-4, **caractérisé en ce que** la variation de la tension u(t) dans le temps t satisfait aux rapports suivantes :

$$u(t) = 0 \quad \text{pour} \ t < 0,$$

$$u(t) = 2U_0 \times \left(\frac{t}{t_0}\right)^2 \qquad \text{pour} \quad 0 \leq t \leq \frac{t_0}{2},$$

$$u(t) = U_0 \times \left[1 - 2 \times \left(1 - \frac{t}{t_0}\right)^2\right] \qquad \text{pour} \quad \frac{t_0}{2} \leq t \leq t_0,$$

$$u(t) = U_0 \qquad \text{pour} \quad t > t_0,$$

$U_0$ étant une tension prédéterminée, et $t_0$ étant un intervalle de temps prédéterminé, lequel est plus long que 100 ms.

**7.** Procédé selon l'une des revendications 2-4, **caractérisé en ce que** la variation de la tension u(t) dans le temps t satisfait aux rapports suivantes :

$$u(t) = 0 \qquad \text{pour } t < 0,$$

$$u(t) = U_0 \times \sin^2\left(\frac{\pi}{2} \times \frac{t}{t_0}\right) \qquad \text{pour} \quad 0 \leq t \leq t_0,$$

$$u(t) = U_0 \qquad \text{pour} \quad t > t_0,$$

$U_0$ étant une tension prédéterminée, et $t_0$ étant un intervalle de temps prédéterminé, lequel est plus long que 100 ms.

**8.** Procédé selon l'une des revendications 5-7, **caractérisé en ce que** $U_0$ est supérieur à 100 V.

**9.** Procédé selon l'une des revendications précédentes, **caractérisé en ce que** l'intervalle de temps prédéterminé est plus long que 10 minutes.

**10.** Procédé selon l'une des revendications précédentes, **caractérisé en ce que** le dispositif de génie énergétique est un transformateur de forte puissance (6).

**11.** Dispositif pour mesurer une impédance d'une isolation d'un dispositif de génie énergétique (6), le dispositif (5) étant réalisé de manière à ce que le dispositif (5) applique un signal de test au dispositif de génie énergétique (6) de manière à ce que le signal de test, en partant d'une valeur initiale, augmente de façon continue monotone jusqu'à une valeur finale prédéterminée ($U_0$) et conserve cette valeur finale ($U_0$) tout au long d'un intervalle de temps prédéterminé, et le dispositif (5) étant réalisé de manière à ce que le dispositif (5) pour mesurer l'impédance de l'isolation mesure à partir du début de l'application du signal tout au long de l'intervalle de temps prédéterminé une variation de courant (22 ; 32 ; 42) d'un courant dans un dispositif de génie énergétique (6).

**12.** Dispositif selon la revendication 11, **caractérisé en ce que** le dispositif (5) comprend un générateur de tension (2), des moyens de mesure de courant (3) et des moyens d'évaluation (4), le générateur de tension (2) générant une tension en tant que signal de test et l'appliquant en tant que la tension au dispositif de génie énergétique (6),

les moyens de mesure de courant (3) mesurant la variation du courant (22 ; 32 ; 42) dans le dispositif de génie énergétique (6), et

les moyens d'évaluation (4) déterminant, à partir d'un rapport entre une variation de tension (21 ; 31 ; 41) de la tension et la variation du courant (22 ; 32 ; 42), l'impédance de l'isolation du dispositif de génie énergétique (6).

13. Dispositif selon la revendication 11 ou 12, **caractérisé en ce que** le dispositif (5) est réalisé pour la mise en oeuvre du procédé selon l'une des revendications 1-10.

FIG. 1

FIG. 2a

FIG. 2b

FIG. 3a

FIG. 3b

FIG. 4a

FIG. 4b

17

FIG. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030065461 A1

- DE 10135915 B4

**In der Beschreibung aufgeführte Nicht-Patentliteratur**

- **von F. Perezalonso ; anderen.** Electrical Characterization of VLSI Packages. *Electronic Components and Technology Conference, 1991, IEEE Proceedings,* 1991, ISBN 978-0-7803-0012-5, 62-69

- **von E. David.** Modeling of the Dielectric Response of a Stator Winding Insulation from DC Ramp Test. *IEEE Transactions on Dielectrics and Electrical Insulation,* Dezember 2007, ISSN 1070-9878, 1548-1558